# EUROPÄISCHE PATENTANMELDUNG

(11) **EP 1 283 663 A2**
(43) Veröffentlichungstag der Anmeldung: **12.02.2003**
(21) Anmeldenummer: 02102118.3
(22) Anmeldetag: 09.08.2002
(51) Int. Cl.: H05K 1/16

(54) **Leiterplatte**

(30) Priorität: 11.08.2001 DE 10139707
(71) Anmelder: Philips Corporate Intellectual Property GmbH, 20099 Hamburg (DE); Koninklijke Philips Electronics N.V., 5621 BA Eindhoven (NL)
(72) Erfinder: Waffenschmidt, Eberhard, c/o Philips Corp.Intel., 52088, Aachen (DE)
(74) Vertreter: Volmer, Georg, Dipl.-Ing.

(57) **Zusammenfassung**

Die Erfindung betrifft eine Leiterplatte mit kapazitiven und induktiven Bauelementen. Um eine solche Leiterplatte so auszugestalten, dass sie eine geringe Dicke aufweist und kostengünstig herstellbar ist, wird eine Leiterplatte mit mindestens einer dielektrischen Schicht, auf deren beiden Seitenflächen in einem ersten Bereich gegenüberliegende Kondensatorelektroden angeordnet sind, wobei in mindestens einem zweiten Bereich neben dem ersten Bereich auf den Seitenflächen der dielektrischen Schicht zwei gegenüberliegende planare Wicklungen angeordnet sind, vorgeschlagen.

## Beschreibung

In der US 5,990,776 ist eine mehrschichtige Leiterplatte beschrieben, bei der aufverschiedenen inneren Leiterplattenschichten planare Spulen- und Transformatorwicklungen angeordnet sind. Durch Verwendung von planaren Wicklungen lassen sich dünne Leiterplatten realisieren, da oberflächenmontierte induktive Schaltungselemente, d.h. Spulen und Transformatoren, nicht mehr notwendig sind. In der US 5,990,776 sind weiterhin die Leiterplatte durchsetzende weichmagnetische Kerne vorgesehen, die den magnetischen Fluss der planaren Spulen- und Transformatorwicklungen führen.

Der Erfindung liegt die Aufgabe zugrunde, eine Leiterplatte mit kapazitiven und induktiven Bauelementen zu schaffen, die eine geringe Dicke aufweist und die kostengünstig herstellbar ist.

Die Aufgabe wird gelöst durch eine mehrschichtige Leiterplatte mit mindestens einer dielektrischen Schicht, auf deren beiden Seitenflächen in einem ersten Bereich gegenüberliegende Kondensatorelektroden angeordnet sind, wobei in mindestens einem zweiten Bereich neben dem ersten Bereich auf den Seitenflächen der dielektrischen Schicht zwei gegenüberliegende planare Wicklungen angeordnet sind.

Bei dieser vorzugsweise durch Laminierung hergestellten Leiterplatte kann sich eine dielektrische Schicht, die aus Material mit erhöhter Dielektrizitätskonstanten besteht und als Kondensatordielektrikum geeignet ist, bis in Bereiche erstrecken, wo planare Wicklungen für induktive Schaltungselemente, LC-Schaltungselemente (L: Induktivitäts-Funktion; C: Kapazitäts-Funktion) oder auch LCT-Schaltungselemente (L: Induktivitäts-Funktion; C: Kapazitäts-Funktion; T: Transformator-Funktion) liegen. Eine dielektrische Schicht kann sich also über die gesamte Leiterplatte erstrecken. Kapazitive Schaltungselemente entstehen auch im zweiten Bereich, der zusätzlich zur Realisierung von induktiven Schaltungselementen dient. Hierdurch kann die Anzahl der erforderlichen Leiterplattenschichten reduziert werden, da unmittelbar auf den Seiten einer dielektrischen Schicht Wicklungen für induktive Schaltungselemente angeordnet werden, mithin keine zusätzliche Schicht für diese Wicklungen erforderlich ist. Durch die Integration von induktiven und kapazitiven Schaltungselementen im zweiten Bereich wird auch die Leiterplattenbreite reduziert. Der Herstellungsprozess wird vereinfacht und Fehlerquellen bei der Herstellung der Leiterplatte beseitigt. Weiterhin sorgt die Erfindung für verbesserte EMI-Eigenschaften (Electro Magnetic Interference) der Leiterplatte. Es können auch Isolierschichten (Anspruch 2) und weitere dielektrische Schichten vorgesehen werden und der zweite Bereich kann je nach Schaltungsanforderung eine Vielzahl von planaren Wicklungen aufweisen. Auch kann eine Vielzahl von zweiten Bereichen vorgesehen sein.

Die Ansprüche 3 bis 5 geben verschiedene Ausführungsvarianten für die planaren Wicklungen des zweiten Bereichs an. So wirken diese als LC-Element, wenn sie auch als Kondensatorelektroden eingesetzt werden, in die die dielektrische Schicht eingreift. Eine weitere Variationsmöglichkeit besteht in der Variation der Wicklungsorientierungen.

Anspruch 6 beschreibt ein Merkmal zur Erweiterung der Funktion der planaren Wicklungen des zweiten Bereichs zu einem LCT-Element, wobei die dritte planare Wicklung und gegebenenfalls weitere dritte planare Wicklungen eine Transformatorwicklung bilden. Die Ansprüche 7 bis 10 beschreiben Varianten mit Magnetkernteilen, die insbesondere die EMI-Eigenschaften der Leiterplatte verbessern. Sie sind beispielsweise mittels die Leiterplatte durchsetzender Kernteile oder mittels planarer Kernteile gebildet. Auch Widerstandselemente lassen sich ebenso wie Halbleiterbauelemente und CMC-Kondensatoren zusätzlich in das Innere der Leiterplatte verlegen (Anspruch 11 und 12). Mittels einer Lage aus weichmagnetischem Material, das derart strukturiert ist, dass entstehende Teilbereiche der Lage, die wenigstens teilweise voneinander getrennt sind (z. B. durch Schlitze oder Löcher), lassen sich mit einer Lage verschiedene Funktionen wie beispielsweise Abschirmung oder die Bildung weichmagnetischer Kernteile realisieren.

Der Gegenstand von Anspruch 14, der auch als unabhängiger Erfindungsgedanke anzusehen ist, beschreibt die Nutzung von Magnetmateriallagen sowohl zur Bildung von magnetischen Bauelementen als auch zur Bildung von Widerstandsbauelementen.

Ausführungsbeispiele der Erfindung werden nachstehend anhand der Zeichnungen näher erläutert. Es zeigen:
- Fig. 1: ein erstes Beispiel einer erfindungsgemäßen Leiterplatte im Querschnitt,
- Fig. 2: in der Leiterplatte nach Fig. 1 verwendete planare Spulenwicklungen in Draufsicht,
- Fig. 3: die Leiterplatte in einschichtiger Ausführungsform im Querschnitt,
- Fig. 4: eine Wicklungsanordnung für die Leiterplatte nach Fig. 3 in Draufsicht,
- Fig. 5: die Leiterplatte in dreischichtiger Ausführungsform im Querschnitt,
- Fig. 6: die Leiterplatte mit Kern im Querschnitt,
- Fig. 7: die Leiterplatte mit Kern und LC-Element im Querschnitt,
- Fig. 8: eine erste Wicklungsanordnung für die Leiterplatte nach Fig. 4 in Draufsicht,
- Fig. 9: eine zweite Wicklungsanordnung für die Leiteplatte nach Fig. 4 in Draufsicht,
- Fig. 10: die Leiterplatte mit einem LCT-Element im Querschnitt,
- Fig. 11: eine Wicklungsanordnung für die Leiterplatte nach Fig. 7 in Draufsicht,
- Fig. 12: die Leiterplatte mit planaren Kernteilen im Querschnitt,
- Fig. 13: eine Wicklungsanordnung für die Leiterplatte nach Fig. 9 in Draufsicht,
- Fig. 14: die Leiterplatte mit eingebetteten planaren Kernteilen im Querschnitt,
- Fig. 15: die Leiterplatte mit zusätzlichen eingebetteten Widerstandselementen im Querschnitt,
- Fig. 16: die Leiterplatte mit zusätzlichen eingebetteten Halbleiterbauelementen im Querschnitt,
- Fig. 17: die Leiterplatte mit einem zusätzlichen Filter im Querschnitt und
- Fig. 18: ein Beispiel für ein Schaltungslayout mit Magnetkernen und Widerständen aus demselben Material.

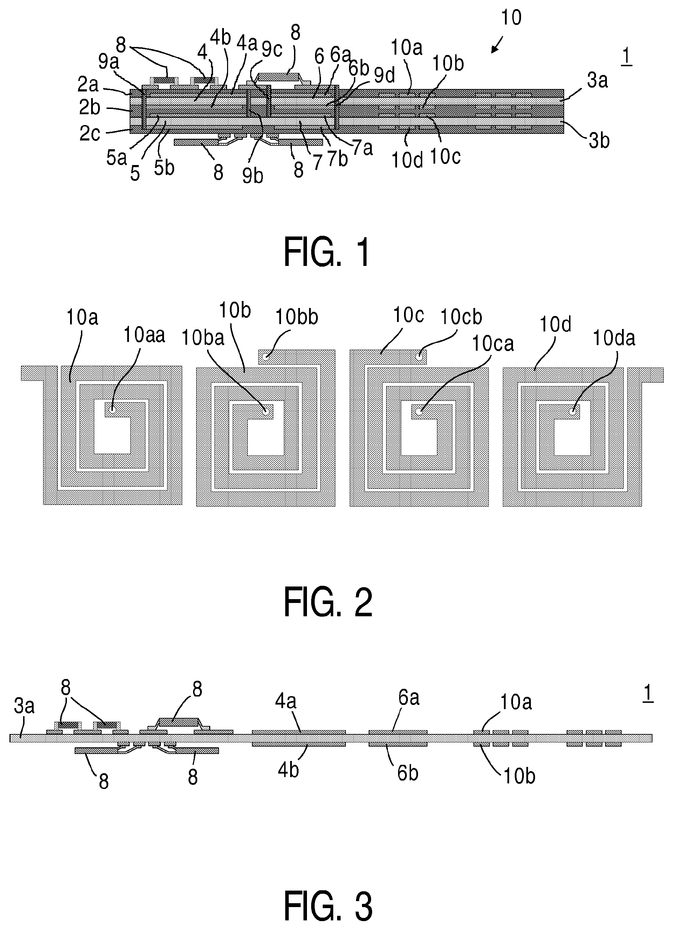

Die in Fig. 1 in einem Querschnitt gezeigte laminierte mehrschichtige Leiterplatte 1 weist drei Isolierschichten 2a, 2b und 2c auf. Zwischen den außen liegenden Isolierschichten 2a und 2c und der innen liegenden Isolierschicht 2b sind dielektrische Schichten 3a und 3b angeordnet, die sich über die gesamte Breite der Leiterplatte 1 erstrecken. Eine dielektrische Schicht im Sinne dieser Anmeldung ist eine Schicht mit für die Anwendung als Dielektrikum in Kondensatoren geeigneter hoher Dielektrizitätskonstanten gemeint. In einem ersten Bereich der Leiterplatte 1 sind mehrere Kondensatorelektroden 4a, 4b, 5a, 5b, 6a, 6b, 7a und 7b angeordnet. Die gegenüberliegenden Elektrodenpaare 4a/4b, 5a/5b, 6a/6b und 7a/7b dienen zur Bildung von vier Kondensatoren 4, 5, 6 und 7. Die Elektrodenpaare 4a/4b und 6a/6b liegen nebeneinander auf der dielektrischen Schicht 3a auf. Die Elektrodenpaare 5a/5b und 7a/7b liegen nebeneinander auf der dielektrischen Schicht 3b auf. Auf der Ober- und Unterseite der Leiterplatte 1 sind Schaltungsstrukturen mit SMD-Bauelementen 8 aufgebracht, von denen einige beispielhaft dargestellt sind. Die elektrische Verbindungen zwischen den Kondensatoren 4, 5, 6 und 7 und den Schaltungsstrukturen mit den Bauelementen 8 werden mittels als Durchgangsbohrungen, die innen mit elektrisch leitfähigem Material versehen sind, ausgeführte sogenannte Vias 9a, 9b, 9c und 9d hergestellt, wobei im vorliegenden Ausführungsbeispiel das Via 9a mit den Elektroden 4b und 5b, das Via 9b mit den Elektroden 4a und 5a, das Via 9c mit den Elektroden 6a und 7a und das Via 9d mit den Elektroden 6b und 7b verbunden ist. Die Kondensatoren 4 bis 7 sind beispielsweise in eine Controllerschaltung einer Stromversorgungsschaltung integriert oder werden als Filterkondensatoren zur Reduzierung von EMI eingesetzt.

In einem rechts neben dem ersten Bereich liegenden zweiten Bereich auf der Leiterplatte 1 ist eine Spule 10 angeordnet. Die Spule 10 besteht aus in Reihe geschalteten planaren Wicklungen 10a, 10b, 10c und 10d, die in Fig. 2 dargestellt sind und die hier jeweils drei spiralförmige Windungen aufweisen; über jeweils ein Via (nicht dargestellt) ist der Kontaktpunkt 10aa mit dem Kontaktpunkt 10ba, der Kontaktpunkt 10bb mit dem Kontaktpunkt 10cb und der Kontaktpunkt 10ca mit dem Kontaktpunkt 10da elektrisch verbunden. Die Wicklungen 10a und 10b liegen auf der dielektrischen Schicht 3a auf. Die Wicklungen 10c und 10d liegen auf der dielektrischen Schicht 3b auf. Die dielektischen Schichten 3a und 3b reichen somit in den Bereich zwischen den planaren Wicklungen 10a und 10b bzw. 10c und 10d hinein. Auf diese Weise entsteht ein Parallelresonanzkreis, der beispielsweise in Konverterschaltungen (Spannungswandlerschaltungen) als Teil eines Filters (z. B. Bandpassfilter) oder in resonanten oder quasi-resonanten Konvertern ohne Netztrennung (z. B. Hochsetzsteller (Boost-Converter), Tiefsetzsteller (down converter) einsetzbar ist.

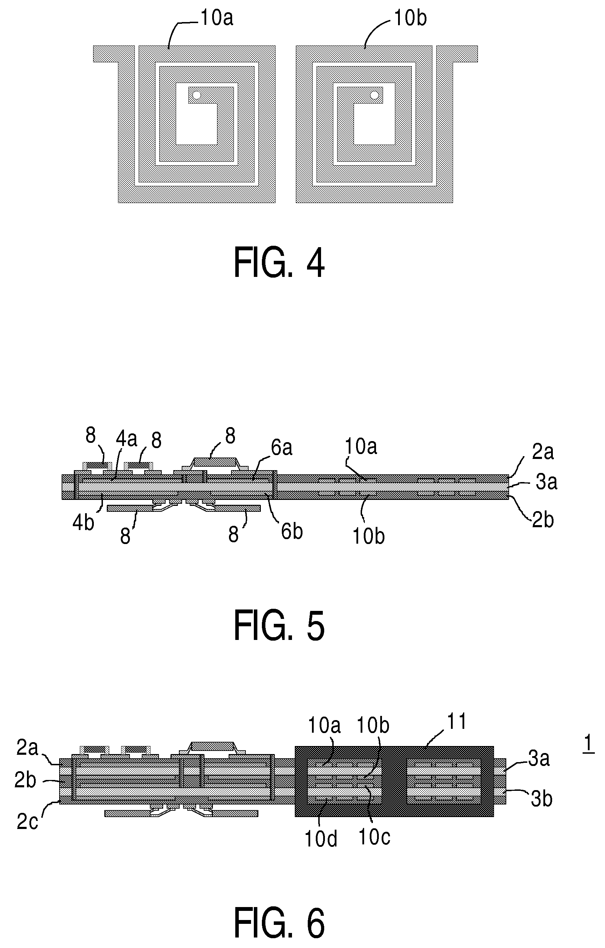

Fig. 3 zeigt die Leiterplatte 1 in einschichtiger Ausführung, bei der lediglich eine Schicht 3a aus dielektrischem Material vorgesehen ist, die gleichzeitig als Träger für die Schaltungselemente der Leiterplatte 1 dient. Eingezeichnet sind das Kondensatorelektrodenpaar 4a und 4b, das Kondensatorelektrodenpaar 6a und 6b, die auf der Ober- bzw. Unterseiter der Leiterplatte gegenüber angeordneten planaren Wicklungen 10a und 10b sowie die weiteren Bauelemente 8. Eine Draufsicht der planaren Wicklungen 10a und 10b zeigt Fig. 4, wo die Wicklungen gleichsinnig angeordnet sind, so dass bei einem Stromfluss die Wicklungsströme entgegen dem Uhrzeigersinn fließen.

Bei dem Ausführungsbeispiel gemäß Fig. 5 ist die Leiterplatte 1 dreischichtig ausgeführt, wobei auf der Oberseite der dielektrischen Schicht 3a die Isolierschicht 2a und auf der Unterseite der dielektrischen Schicht 3a die Isolierschicht 2b angeordnet ist. Das Kondensatorelektrodenpaar 4a und 4b und das Kondensatorelektrodenpaar 6a und 6b sowie die planaren Wicklungen 10a und 10b sind im Inneren der Leiterplatte 1 wie in Fig. 1 zwischen den außen liegenden Isolierschichten 2a und 2b und der innen liegenden dielektrischen Schicht 3a angeordnet. Die Bauelemente 8 sind auf der Ober- und Unterseite und damit auf den Isolierschichten 2a und 2b angeordnet.

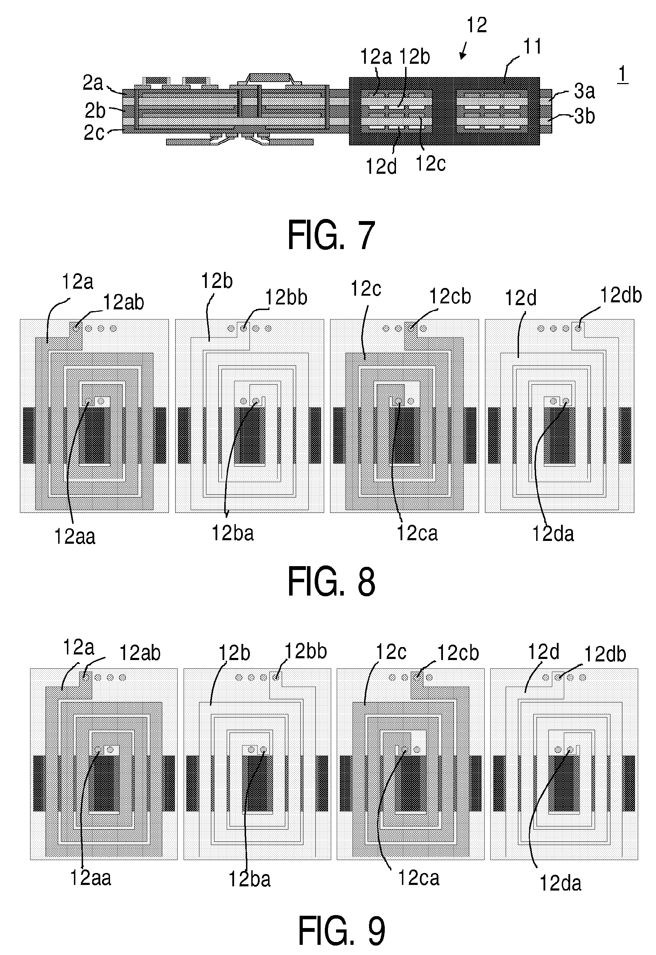

Fig. 6 zeigt die Leiterplatte 1 aus Fig. 1 mit einem zusätzlichen Magnetkern 11, der zur Erhöhung der Induktivität der Spule 10 dient. Der Kern 11 ist beispielsweise als E-Kern oder als Topfkern ausgeführt. Es kann ein Luftspalt vorgesehen werden, um die Induktivität und die magnetische Flussdichte einzustellen.

Fig. 7 zeigt eine Variante der Leiterplatte 1, bei der anstelle der Spule 10 ein LC-Element 12 vorgesehen ist. Das LC-Element 12 weist planare Wicklungen 12a, 12b, 12c und 12d mit hier jeweils drei spiralförmigen Windungen auf, die in der Ausführungsform gleichsinniger Wicklungen in Fig. 8 und in der Ausführungsform gegensinniger Wicklungen in Fig. 9 dargestellt sind. In Fig. 8 verlaufen alle Ströme entgegen der Uhrzeigerrichtung und in Fig. 9 verlaufen Ströme durch die Wicklungen 12a und 12c entgegen der Uhrzeigerrichtung und Ströme durch die Wicklungen 12b und 12d in Uhrzeigerrichtung. Die Wicklungen 12a, 12b, 12c und 12d weisen Kontaktpunkte 12aa, 12ba, 12ca und 12da auf. Kontaktpunkt 12aa ist mit dem Kontaktpunkt 12ca und der Kontaktpunkt 12ba ist mit dem Kontaktpunkt 12da über jeweils ein Via (nicht dargestellt) elektrisch verbunden. Die Kontaktierung der Wicklungen 12a, 12b, 12c und 12d mit den übrigen Schaltungsstrukturen der Leiterplatte 1 erfolgt an den Kontaktpunkten 12ab, 12bb, 12cb und 12db - vorzugsweise wiederum über Vias.

Die sich gegenüberliegenden Wicklungen 12a und 12b sowie 12c und 12d haben neben ihrer induktiven Wirkung ebenso die Funktion von Kondensatorelektroden, wobei als Dielektrikum die Schicht 3a bzw. 3b dient.

Als Anwendungen der Ausführungsform nach Fig. 7 und 8 kommen beispielsweise ein Einsatz in Gleichtakt-Drosseln mit integrierter Gegentakt-Kapazität zur Reduktion von EMI in Leistungswandlern oder auch der Einsatz in einem Parallelresonanzkreis wie bei der Ausführungsform in Fig. 6 - allerdings mit erheblich erhöhter effektiver Kapazität - in Betracht. Auch eine Anwendung in Serienresonanzkreisen ist möglich. Anwendungen sind beispielsweise Bandpassfilter oder Schwingkreise für resonante oder quasi-resonante Stromversorgungskonverter oder die Verwendung des Serienkondensators als DC-Entkoppelkondensator.

Bei der Ausführungsform nach Fig. 7 und 9 kommen beispielsweise folgende Anwendungen in Betracht: Gegentakt-Filter mit integrierter Kapazität zur Reduzierung von EMI von Leistungskonvertern; Konverterdrosseln in Kombination mit Filterkondensatoren (beispielsweise für Hochsetzsteller oder Tiefsetzsteller); Parallelresonanzschaltkreise wie bei der Ausführungsform in Fig. 6 - allerdings mit erheblich erhöhter effektiver Kapazität; Serien-Parallel-Resonanzschaltkreise; Anwendung in Leistungsschaltkreisen wie Schwingkreise von resonanten oder quasi-resonanten Konvertern.

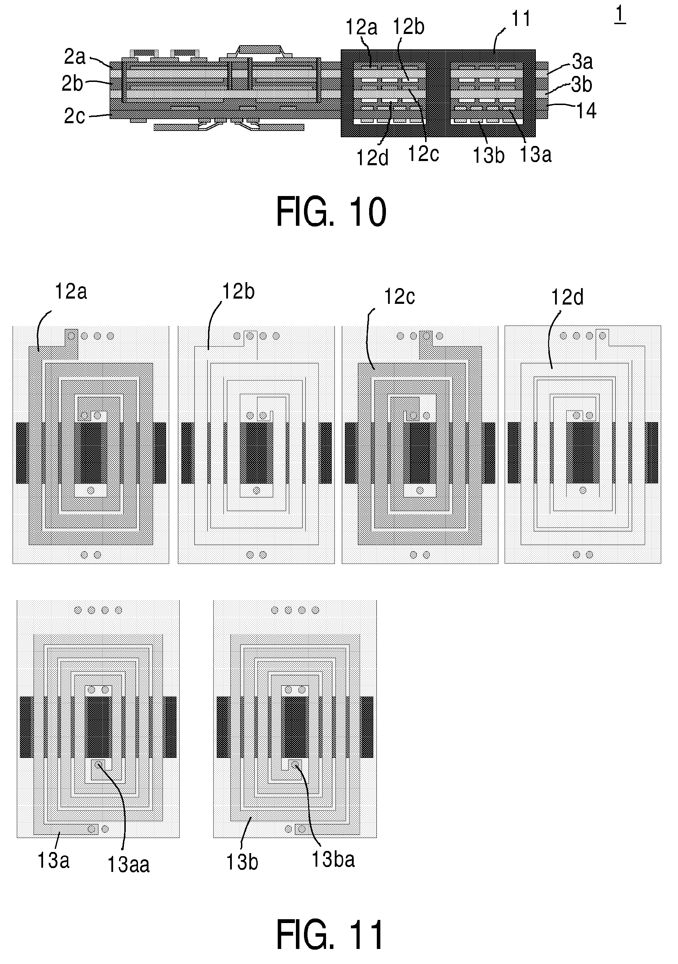

Bei der Ausgestaltung der Leiterplatte 1 nach Fig. 10 und 11 sind zwei weitere planare Wicklungen 13a und 13b vorgesehen, die in Fig. 8 dargestellt sind und hier jeweils vier Windungen aufweisen. Die sich gegenüberliegenden Wicklungen 13a und 13b sind auf der Ober- und Unterseite einer weiteren Isolierschicht 14 angeordnet und in Reihe geschaltet, wobei Kontaktpunkte 13aa und 13ba mittels eines Vias (nicht dargestellt) elektrisch verbunden sind. Die Wicklungen 13a und 13b wirken als Sekundärwicklung für die Transformator-Komponente des zusammen mit den Wicklungen 12a, 12b, 12c und 12d gebildeten LCT-Elements, wobei die Primärwicklungsfunktion durch die Wicklungspaare 12a-12c und/oder 12b-12d je nach Verschaltung ausgeübt wird. Die Zentralbereiche der Wicklungen 12a, 12b, 12c, 12d, 13a und 13b liegen auf einer Linie entlang derer der Mittelsteg des Magnetkerns 11 geführt ist und der zur Führung eines magnetischen Flusses durch die Wicklungen 12a, 12b, 12c, 12d, 13a und 13b dient. Die Wicklungen 12a bis 12d verlaufen hier gleichsinnig wie in Fig. 5; ein gegensinniger Verlauf wie in Fig. 6 ist natürlich auch möglich.

Die Ausführungsform der Leiterplatte 1 nach Fig. 10 und 11 kann bevorzugt in resonanten oder quasi-resonanten Konvertern eingesetzt werden, wobei die Realisierung von Serienresonanzkreisen, Parallelresonanzkreisen als auch von Resonanzkreisen mit Serien- und Parallelresonanz möglich ist. Weitere Anwendungen sind Gegentaktfilter oder Gleichtaktfilter, wobei mittels einer auf der Transformatorsekundärseite angeschlossener Impedanz die Dämpfungseigenschaften des Filters einstellbar sind. Auch kann über die Wicklungen 13a und 13b eine Detektion oder Einspeisung von als Kommunikationssignale dienenden Hochfrequenz-Gleichtaktsignalen oder Hochfrequenz-Gegentaktsignalen erfolgen, wobei die Signalübertragung über Versorgungsspannungen führende Leitungen erfolgt.

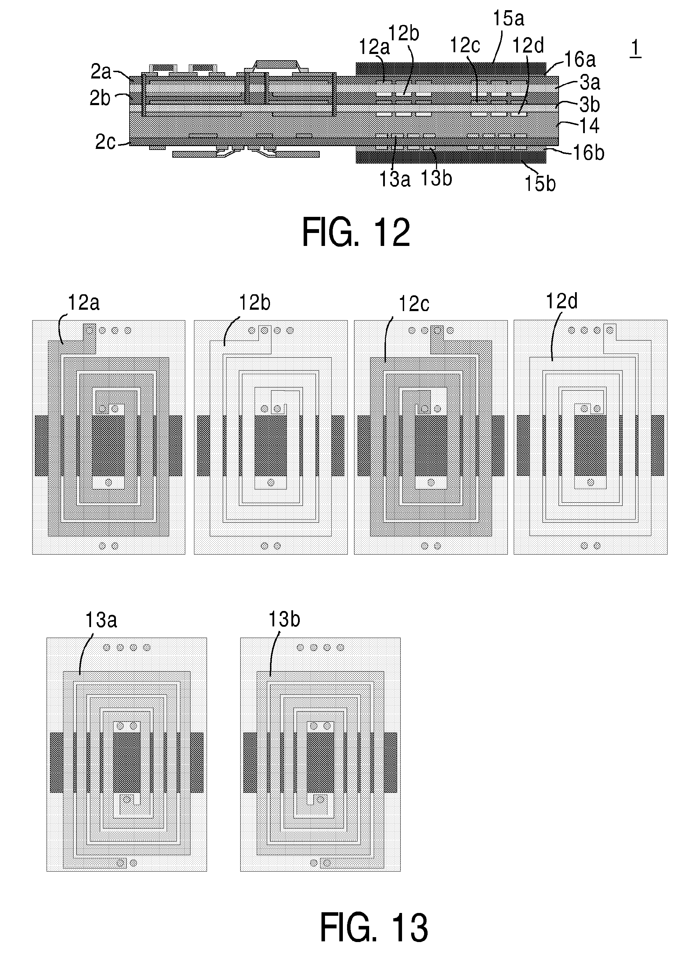

Bei der Ausführungsform der Leiterplatte nach Fig. 12 ist anstelle des die Leiterplatte 1 durchsetzenden Magnetkerns 11 ein Magnetkern aus zwei planaren Magnetkernteilen 15a und 15b vorgesehen. Als Magnetkernmaterial können handelsübliche Ferritplatten, kunststoffgebundenes Ferrit (Ferroplast, Ferrite Polymer Compound) und NiFe-Metallschichten (µ-Metall, Permalloy, Vitrovac) verwendet werden. Die beiden Kernteile 15a und 15b sind mittels Klebverbindungen 16a und 16b auf der Ober- bzw. Unterseite der Leiterplatte 1 gegenüber den Wicklungen 12a bis 12d, 13a und 13b angeordnet. Die von den Kernteilen 15a und 15b überdeckte Fläche ist so groß gewählt, dass ein magnetischer Fluss auch seitlich um die Wicklungen 12a bis 12d, 13a und 13b herum in für die jeweilige Anwendung ausreichender Weise geführt wird. Fig. 13 zeigt die Anordnung der planaren Wicklungen 12a, 12b, 12c, 12d, 13a und 13b. Durch Vermeidung von Löchern durch die Leiterplatte 1 wie bei einer Verwendung des Kerns 11 lassen sich Netztrennungsprobleme reduzieren. Insbesondere kann die zulässige Kriechstrecke zwischen Primär- und Sekundärseite erheblich reduziert werden.

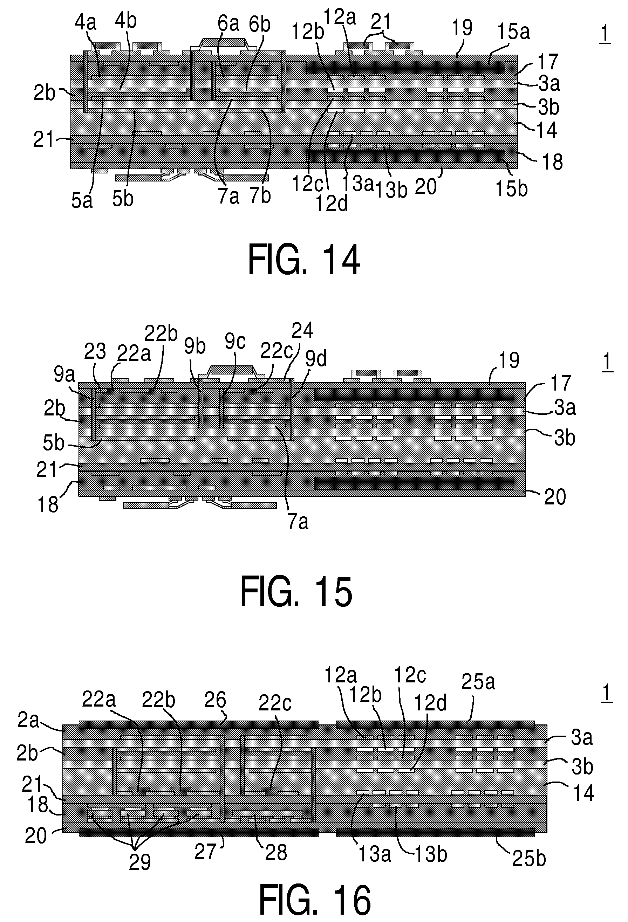

Bei der Ausgestaltung in Fig. 14 sind die Kernteile 15a und 15b in die Leiterplatte 1 einlaminiert. Auf die dielektrische Schicht 3a ist anstelle der Schicht 2a eine Isolierschicht 17 zum Tragen des Kernteils 15a aufgebracht. Weiterhin ist auf die Isolierschicht 14 anstelle der Isolierschicht 2c eine Isolierschicht 18 zum Tragen des Kernteils 15b aufgebracht. Auf die Isolierschicht 17 ist eine weitere Isolierschicht 19 und auf die Isolierschicht 18 ist eine weitere Isolierschicht 20 aufgebracht, wobei hier die Schichten 19 und 20 die Außenschichten der Leiterplatte 1 darstellen. Auf diese Weise wird es ermöglicht, auf den Außenseiten der Leiterplatte 1 auch im Bereich über den Kernteilen 15a und 15b Schaltungselemente, insbesondere auch einzelne SMD-Bauelemente anzuordnen, wie dies durch die Bauelemente 21 angedeutet ist, d.h. es wird zusätzlicher Platz für solche Schaltungsteile geschaffen. Die Anordnung von Kondensatorelektroden 4a, 4b, 5a, 5b, 6a, 6b, 7a, 7b auf Unter-und Oberseite der dielektrischen Schichten 3a und 3b erfolgt entsprechend den Ausführungsformen nach Fig. 1 bis 13.

Fig. 15 zeigt eine Weiterbildung der Ausgestaltung gemäß Fig. 14, bei der zusätzlich Widerstandselemente in die Leiterplatte 1 integriert sind, die durch Verwendung einer Widerstandspaste oder durch strukturierte Lagen (z. B. Omega Ply Verfahren) hergestellt werden. Beispielhaft sind Widerstandselemente 22a, 22b und 22c dargestellt, die auf der Schicht 17 aufgebracht sind. Eine Verbindungsleitung 23 verbindet die Elemente 22a und 22b miteinander und ist außerdem mit dem Via 9a verbunden, so dass eine elektrische Verbindung mit der Kondensatorelektrode 5b hergestellt ist. Das Widerstandselement 22c ist mittels einer Verbindungsleitung 24 mit dem Via 9c und damit mit der Kondensatorelektrode 7a elektrisch verbunden.

Fig. 16 zeigt eine Variante der Leiterplatte 1, bei der wie in Fig. 15 zwei planare Magnetkernteile oberhalb und unterhalb der Wicklungen 12a, 12b, 12c, 12d, 13a und 13b angeordnet sind, und zwar das Magnetkernteil 25a auf der Oberseite der Leiterplatte 1 und das Magnetkernteil 25b auf der Unterseite der Leiterplatte 1. Zusätzlich ist neben dem Magnetkernteil 25a ein weiteres planares weichmagnetisches Teil 26 und neben dem Magnetkernteil 25b ein weiteres weichmagnetisches Teil 27 angeordnet, die lediglich zur Abschirmung dienen, so dass der Großteil der Leiterplattenoberseite als auch der Großteil der Leiterplattenunterseite abgeschirmt sind. Auf diese Weise können EMI-Probleme effektive reduziert werden; die Teile 25a, 25b, 26 und 27 können auch aus einer einzige Lage aus weichmagnetischem Material gebildet werden, in die Schlitze oder auch Löcher zum Entkoppeln der verschiedenen Teile eingebracht (beispielsweise durch Ausstanzen) sind, und können auch im Inneren der Leiterplatte 1 angeordnet werden. Weiterhin sind bei diesem Ausführungsbeispiel in die Leiterplatte 1 Halbleiterbauelemente 28 und 29 integriert, die auf der Isolierschicht 20 bzw. zwischen der Isolierschicht 20 und der Isolierschicht 21 angeordnet sind. Vorzugsweise werden sogenannte "flip chip type semiconductors" (Bauelement 28), die besonders flach und somit laminierbar sind, verwendet. Weiterhin möglich sind Bauelemente mit elektrischen Kontakten auf der Ober- und der Unterseite (Bauelemente 29), die keines Gehäuses bedürfen (was eine verbesserte Wärmeabführung ermöglicht) und nicht verlötet werden müssen, da der elektrische Kontakt durch mechanischen Anpressdruck sichergestellt ist. Gegebenenfalls kann der elektrische Kontakt durch die Verwendung von Kontaktfedern sichergestellt werden. Die Widerstandselemente 22a, 22b und 22c sind hier zwischen den Leiterplattenschichten 14 und 21 angeordnet.

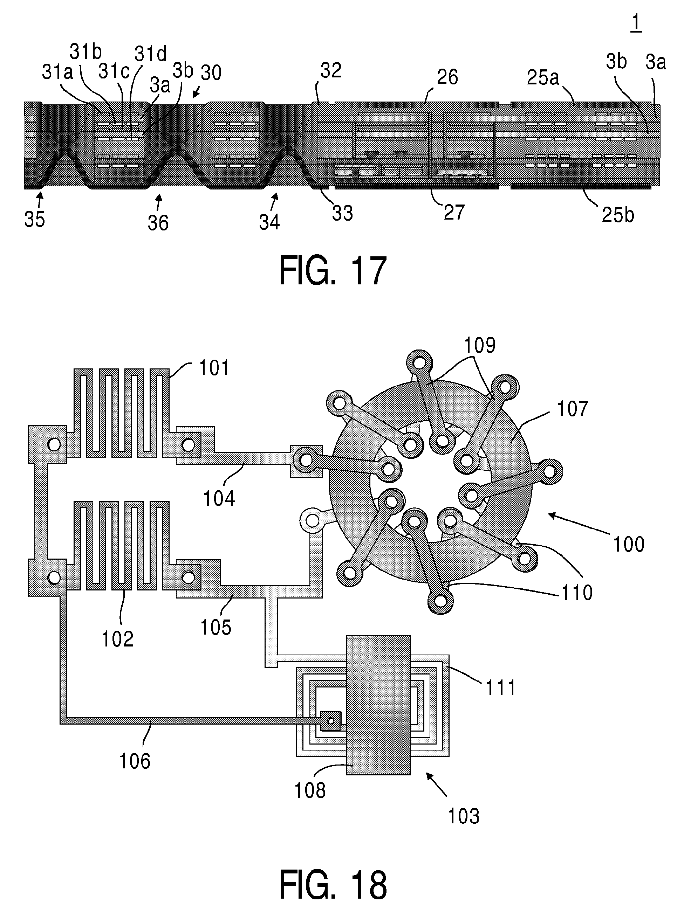

Fig. 17 zeigt die Leiterplatte 1 aus Fig. 16 nach links erweitert um einen Leiterplattenbereich mit einer LC-Komponente 30, die wie die LC-Komponente 12 bei der Leiterplatte in Fig. 4 aufgebaut ist, d.h. deren planare Wicklungen jeweils oberhalb und unterhalb der dielektrischen Schichten 3a und 3b angeordnet sind. Den Wicklungen 12a, 12b, 12c und 12d entsprechen bei der LC-Komponente 30 die Wicklungen 31a, 31b, 31c und 31d. Es sind planare Magnetkernteile 32 und 33 vorgesehen, die sich über die LC-Komponente 30 erstrecken und in unmittelbar neben der LC-Komponente 30 liegenden Bereichen 34 und 35 als auch im Zentralbereich 36 der LC-Komponente 30 in durch Ausfräsen oder Ausstanzen hergestellte Ausnehmungen eingreifen, so dass der Abstand zwischen den Magnetkernteilen 32 und 33 in diesen Bereich reduziert ist; im vorliegenden Beispiel ist der Abstand auf Null reduziert, d.h. die Magnetkernteile 32 und 33 berühren sich in den Bereichen 34, 35 und 36, so dass ein von dem LC-Element 30 produzierter magnetischer Fluss ähnlich gut wie bei einem E-Kern oder Topfkern geführt wird. Ein Ausfüllen der Ausnehmungen durch Material der Magnetkernteile 32 und 33 ist einerseits möglich durch Spritzguss oder auch durch thermisches Verformen beim Laminieren (möglich bei Ferroplasten).

Bei Verwendung von µ-Metall kann ein Ausfüllen der Ausnehmungen auch durch Biegen der µ-Metallschichten erfolgen.

Bei den Fig. 1, 3, 5, 6, 7, 10, 12, 13, 14, 15, 16 und 17 ist zu berücksichtigen, dass die Leiterplatte und deren Komponenten aus Gründen der Übersichtlichkeit nicht maßstabsgerecht dargestellt sind. Die Leiterplattenschichten und Bauelemente gemäß den dargestellten Ausführungsvarianten sind in vertikaler Richtung übertrieben breit dargestellt. Weiterhin lassen sich die verwendeten planaren Wicklungen in unterschiedlicher Weise elektrisch miteinander verbinden, so dass auf diese Weise verschiedene Schaltungsvarianten entstehen.

Fig. 18 zeigt eine weitere Möglichkeit der Ausgestaltung einer laminierten mehrschichtigen Leiterplatte. Die beispielhaft dargestellten Schaltungskomponenten umfassen eine Ringkernspule 100, Widerstandselemente 101 und 102 sowie eine planare Spule 103. Ein Anschluss der Ringkernspule 100 ist mittels einer Leiterbahn 104 mit dem Widerstandselement 101 und der andere Anschluss der Ringkernspule ist mit dem Widerstandselement 102 mittels einer Leiterbahn 105 verbunden. Die Leiterbahn 105 stellt ebenfalls einen Kontakt mit der planaren Spule 103 her, deren anderer Anschluss mittels einer Leiterbahn 106 mit den Widerstandselementen 101 und 102 verbunden ist. Die Spule 100 weist einen planaren Ringkern 107 und die planare Spule einen planaren Kern 108 auf. Die Windungen der Ringkernspule 100 sind aus ersten Leitungsstücken 109, die auf der Oberseite des Ringskerns 107 liegen, und aus zweiten Leitungsstücken 110, die auf der Unterseite des Ringkerns 107 liegen, gebildet. Die drei Windungen aufweisende Wicklung der planaren Spule 103 ist mit 111 bezeichnet.

Die verschiedenen Schaltungselemente der Fig. 18 sind aus drei Lagen hergestellt: einer ersten Kupferlage (104, 105, 110, 111), einer zweiten Kupferlage (106, 109) sowie aus einer Magnetmateriallage (101, 107, 108), wobei zwischen diesen Lagen angeordnete Isolierlagen aus Gründen der Übersichtlichkeit nicht dargestellt sind. Der Ringkern 107, der Kern 108 und die Widerstände 101 und 102 sind somit aus demselben Material hergestellt, d.h. es wird die elektrische Leitfähigkeit von Magnetmaterial - beispielsweise µ-Metall, Eisenpulverkernmaterial, Ferrit, kunststoffgebundenes Ferrit oder Eisenpulver oder Elektrostahl - ausgenutzt. Die Widerstände 101 sind mäanderförmig ausgebildet; je nach Form und Länge des Mäanders lässt sich der gewünschte Widerstandswert einstellen. Wird Ferrit als Magnetkernmaterial gewählt, lassen sich sehr hochohmige Widerstände realisieren; aber auch µ-Metall mit einem Widerstandswert hundertmal größer als Kupfer ist als Magnetkern- und Widerstandsmaterial geeignet. Wenn bei Verwendung von Magnetmateriallagen diese nicht nur für die Realisierung von Magnetkernen, sondern zusätzlich auch für die Realsisierung von Widerständen genutzt werden, wird in diesen Fällen eine effektivere Nutzung des Magnetmaterial erreicht.

Das Ausführungsbeispiel nach Fig. 15 deutet nur eine Vielzahl von Variationsmöglichkeiten an. So kann eine Leiterplatte selbstverständlich mehrere Lagen aus Magnet-Widerstands-Material haben, das magnetische Elemente und Widerstandselemente bildet. Das Magnetmaterial kann beispielsweise auch für Sensoren mit Magnetkernen verwendet werden. Es können zusätzliche kapazitive Lagen in der Leiterplatte integriert oder weitere nicht magnetisch nutzbare Widerstandslagen vorgesehen sein. Auch weitere Lagen aus dem Magnetmaterial, die lediglich zur Bildung magnetischer Bauelemente eingesetzt werden, sind möglich. Strukturen entsprechend dem in Fig. 15 dargestellten Ausführungsbeispiel lassen sich sowohl auf die üblichen Leiterplatten mit Epoxidharz-Substrat als auch auf Leiterplatten mit anderen Substratmaterialien, insbesondere Keramik (z. B. Al₃O₃) oder Halbleitermaterial (Silizium) oder flexiblen Leiterplattenfolien, einsetzen.

## Patentansprüche

1. Leiterplatte (1) mit mindestens einer dielektrischen Schicht (3a, 3b), auf deren beiden Seitenflächen in einem ersten Bereich gegenüberliegende Kondensatorelektroden (4a, 4b, 5a, 5b, 6a, 6b, 7a, 7b) angeordnet sind, wobei in mindestens einem zweiten Bereich neben dem ersten Bereich auf den Seitenflächen der dielektrischen Schicht (3a, 3b) zwei gegenüberliegende planare Wicklungen (10, 12) angeordnet sind.

2. Leiterplatte nach Anspruch 1,
**dadurch gekennzeichnet,**
**dass** die dielektrische Schicht (3a, 3b) zwischen zwei Isolierschichten (2a, 2b, 2c) angeordnet ist.

3. Leiterplatte nach Anspruch 1,
**dadurch gekennzeichnet,**
**dass** die im zweiten Bereich angeordneten planaren Wicklungen (12) sowohl induktiv als auch kapazitiv wirken.

4. Leiterplatte nach Anspruch 1,
**dadurch gekennzeichnet,**
**dass** die beiden planaren Wicklungen gleichsinnige Wicklungsorientierungen aufweisen.

5. Leiterplatte nach Anspruch 1,
**dadurch gekennzeichnet,**
**dass** die beiden planaren Wicklungen gegensinnige Wicklungsorientierungen aufweisen.

6. Leiterplatte nach einem der Ansprüche 1 bis 5,
**dadurch gekennzeichnet,**
**dass** eine dritte Isolierschicht (2c) vorgesehen ist und
**dass** auf mindestens einer Seite der dritten Isolierschicht (2c) in einem der ersten planaren Wicklung (12a, 12b, 12c, 12d) gegenüberliegenden Bereich mindestens eine weitere von der ersten planaren Wicklung galvanisch getrennte dritte planare Wicklung (13a, 13b) vorgesehen sind.

7. Leiterplatte nach einem der Ansprüche 1 bis 6,
**dadurch gekennzeichnet,**
**dass** zur Führung des durch die planaren Wicklungen (12a, 12b, 12c, 12d, 13a, 13b) erzeugten magnetischen Flusses dienende weichmagnetische Kernteile (15a, 15b) vorgesehen sind.

8. Leiterplatte nach Anspruch 7,
**dadurch gekennzeichnet,**
**dass** die Kernteile die Leiterplatte durchsetzen.

9. Leiterplatte nach Anspruch 7,
**dadurch gekennzeichnet,**
**dass** planare Kernteile vorgesehen sind.

10. Leiterplatte nach Anspruch 9,
**dadurch gekennzeichnet,**
**dass** die Leiterplatte Ausnehmungen (34, 35, 36) aufweist, die mit weichmagnetischem Material gefüllt sind.

11. Leiterplatte nach einem der Ansprüche 1 bis 10,
**dadurch gekennzeichnet,**
**dass** in die Leiterplatte eingebettete Widerstandselemente (22a, 22b, 22c) vorgesehen sind.

12. Leiterplatte, insbesondere nach einem der Ansprüche 1 bis 11,
**dadurch gekennzeichnet,**
**dass** in die Leiterplatte weitere elektronische Bauelemente wie beispielsweise Halbleiterbauelemente und/oder CMC-Kondensatoren eingebettet sind.

13. Leiterplatte nach einem der Ansprüche 1 bis 12,
**dadurch gekennzeichnet,**
**dass** mindestens eine Lage aus weichmagnetischem Material vorgesehen, die derart strukturiert ist, dass verschiedene Teilbereiche der Lage unterschiedliche Funktionen ausüben.

14. Leiterplatte nach einem der Ansprüche 1 bis 13,
**dadurch gekennzeichnet,**
**dass** in einer Leiterplattenebene aus demselben Material gebildete planare Magnetkernteile (107, 108) und planare Widerstandselemente (101, 102) angeordnet sind.
